# EUROPEAN PATENT SPECIFICATION

(11) **EP 2 120 098 B1**
(45) Date of publication and mention of the grant of the patent: **24.09.2014**
(21) Application number: 09158993.7
(22) Date of filing: 28.04.2009
(51) Int. Cl.: G03F 7/34, B41F 13/16, G03G 15/00

(54) **Apparatus and process for positioning a cylindrically-shaped printing element**
Vorrichtung und Verfahren zur Positionierung eines zylinderförmigen Druckelements
Appareil et procédé pour positionner un élément d'impression de forme cylindrique

(30) Priority: 15.05.2008 US 127777 P; 23.04.2009 US 128645
(43) Date of publication of application: 18.11.2009
(73) Proprietor: E. I. du Pont de Nemours and Company, Wilmington, DE 19898 (US)
(72) Inventor: Luetke, Helmut, 65185, Wiesbaden (DE); Vestergaard, Ib, 5690, Tommerup (DK)
(74) Representative: Hoffmann, Benjamin

(56) References cited:
- US-A- 5 316 524
- US-A- 5 806 431
- US-A1- 2006 104 675
- US-A1- 2008 028 966

## Description

### BACKGROUND OF THE INVENTION

### Field of the Invention

This invention pertains to an apparatus for treating a cylindrically-shaped element, and a process for positioning the cylindrically-shaped element in the apparatus. In particular, the apparatus includes a means for moving the element to a pre-defined position for treatment. The cylindrically-shaped element is moved and positioned for treatment in the apparatus, creating a printing form.

### Description of Related Art

Flexographic printing plates are well known for relief printing on a variety of substrates which range from soft and easy to deform to relatively hard, such as packaging materials, e.g., cardboard, plastic films, aluminium foils, etc. Flexographic printing plates can be prepared from photosensitive printing elements containing a layer of a photosensitive composition such as those described in U.S. Patents 4,323,637 and 4,427,759. Photosensitive elements generally have the layer of the photopolymerizable composition interposed between a support and a cover sheet or multilayer cover element. Upon imagewise exposure of the photosensitive element to actinic radiation, photopolymerization of the photosensitive composition occurs in the exposed areas, thereby curing and rendering insoluble the exposed areas of the layer. Conventionally, the element is treated with a suitable solution to remove areas of the photopolymerizable layer that were not exposed and leaving a printing relief which can be used for flexographic printing.

As an alternative to solution development, a "dry" thermal development process may be used which removes the unexposed areas without the subsequent time-consuming drying step. In a thermal development process, the composition layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens) and 5,279,697 (Peterson et al.). The exposed portions of the composition layer remain hard, that is, do not soften or melt, at the softening temperature for the unexposed portions. The absorbent material collects the softened un-irradiated material and then is separated and/or removed from the composition layer.

Processors for thermal development of flexographic printing elements are known, for example, from U.S. Patent 5,279,697 and U.S. Patent 6,797,454. In both thermal processing apparatuses an irradiated photosensitive printing element comprising the support and the composition layer is mounted on a drum and a continuous web of absorbent material is passed over a hot roll. The hot roll is urged towards the drum pressing the web against the photosensitive element and forming a nip. Heat is transferred by conduction from the hot roll, through the absorbent web, to the photosensitive element upon contact so the temperature of the composition layer is raised sufficiently to enable the unirradiated portions of the composition layer to liquefy and be absorbed into the absorbent material. The heat transfer might be assisted by IR radiation using an additional IR heater directed to the surface of the composition layer. As the drum and hot roll rotate in contact together, the web is pressed against the photosensitive element to absorb the liquefied unirradiated composition and is then separated from the element. After the unirradiated composition is removed the resulting element has a raised relief surface of hardened areas that is suitable use as a printing plate.

Besides flat or planar photosensitive printing elements, it is also possible to thermally process cylindrically-shaped photosensitive printing elements, such as seamless photopolymer sleeves, or so called plate-on-sleeves. Seamless photopolymer sleeves include at least a continuous or substantially continuous layer of the photopolymerizable composition on a cylindrical support. Plate-on-sleeves include a flat photosensitive printing element mounted onto a cylindrical support.

Development by commercial processors of cylindrical photosensitive printing elements having different diameters can be difficult, time consuming, and expensive. However, an apparatus and process for thermal development of cylindrical photosensitive printing elements is disclosed in the United States Patent Application Publication 2006/0104675 (EP1657593), which overcomes these problems. The process treats a photosensitive element having a cylindrical support and a composition layer adjacent the support opposite an interior surface of the support, the composition layer capable of being partially liquefied. The apparatus includes first means for supporting the photosensitive element by contacting a first part of the interior surface of the cylindrical support; second means for supporting the photosensitive element by contacting a second part of the interior surface of the cylindrical support different from the first part, wherein the cylindrical support has one or more unsupported parts between the first part and the second part; and means for treating an exterior surface of the photosensitive element opposite the support to form a relief surface in the element. The cylindrical photosensitive element is not fully supported during thermal development. It is only partially supported by the first support means and the second support means of the apparatus. The cylindrical photosensitive element is not firmly fixed on a supporting cylinder, such as a drum, during thermal processing, but it is processed in a so-called "loose-fit" mode. In loose-fit mode, the interior surface of the cylindrical support of the photosensitive element is not fully contacted or supported by a supporting cylinder; and only a part or parts of the interior surface are in contact with or supported by a supporting means. In some cases, the hot roll is urged towards the support means pressing the absorbent material against the cylindrically-shaped printing element and forming a nip. Alternatively, the supported photosensitive element is brought into contact to a fixed heated roll by moving the loose-fit structure into a controlled impression.

A problem sometimes arises when the cylindrical photosensitive element has an axial length less than an axial length of the means for supporting the element in the apparatus, in that the position of the photosensitive element on the support means can influence the uniformity of pressure applied to the along the axial length of the photosensitive element at the contact zone of the nip. It is desirable to assure pressure uniformity on the photosensitive element across the nip since non-uniform application of pressure can contribute to the resulting relief structure of the printing form having non-uniform relief depth. It is desirable to avoid differences in pressure at the nip across the axial length of the processed cylindrically-shaped printing element and to create or maintain a symmetrical pressure profile. Also, the mounting cylindrical printing elements having the axial length less than the axial length of the means for supporting oftentimes causes an operator to insert his arm well into an opening of the apparatus. In some cases, the operator may even need to have some scale or ruler, and most probably a special jig, to move the cylindrical printing element sufficiently into the apparatus. There are some issues associated with the mounting of cylindrical printing elements, particularly those printing elements having its axial length less than the axial length of the support means, into the apparatus including: operators might not have long enough arms to move the printing element into the desired position; operators may touch hot surfaces, such as the heated roll or IR heater compartment, within the apparatus; operators may touch sharp edges and corners of the apparatus; and, operators may experience smells or chemical residues that may emit from inside the apparatus while the operator is moving the element. The removal of the cylindrical printing element after processing has the same associated set of problems.

US 5,806,431 discloses a method and apparatus for axially positioning a printing plate.

US 2008/0028966 disclose a method for feeding a printing form to a form cylinder.

US 5,316,524 discloses an edge guide system for belt tracking.

Therefore, there is a need to overcome the problems of related art and to improve existing processors for thermal development of cylindrically-shaped printing elements. In particular there is a need for a solution that ensures a safe and quick positioning of cylindrically-shaped printing elements of different length.

### SUMMARY OF THE INVENTION

The present invention provides an apparatus for treating and a process for positioning a cylindrically-shaped element as set out in claim 1. The apparatus includes means for supporting the element adapted to contact a first part of an interior surface of the element, the supporting means having an axial length; and means for moving the element along the axial length of the supporting means.

In accordance with another aspect of the invention there is provided a process for positioning a cylindrically-shaped element having an interior surface and a side edge as set out in claim 6, in an apparatus for treating the element. The process includes supporting the element by contacting a first part of an interior surface of the element on a support member having an axial length; engaging a finger into contact with the side edge of the element; and moving the finger on a guide to position the element on the support member.

### BRIEF DESCRIPTION OF THE DRAWINGS

Figure 1 is a schematic side view of one embodiment of an apparatus for treating a cylindrically-shaped element showing one embodiment of a means for moving the element onto a support means.
Figure 2 is a schematic front view of the apparatus showing the moving means axially locating the element on the support means.

### DETAILED DESCRIPTION OF THE PREFERRED EMBODIMENTS

Throughout the following detailed description, similar reference characters refer to similar elements in all figures of the drawings.

The present invention is an apparatus for treating a cylindrically-shaped element, and a process for positioning the cylindrically-shaped element. The process locates the cylindrically-shaped element in an apparatus, in particular in the apparatus for treating, to a predetermined position relative to an operational width, (i.e., axial length) of a support member in the apparatus. The cylindrically-shaped element is appropriately positioned in the apparatus to advantageously avoid differences in pressure across an axial length of the cylindrically-shaped element at a contact zone formed at the nip between the element and a contact member. In the present apparatus and process, the cylindrically-shaped element is positioned on a support member to create or maintain a symmetrical pressure profile on the element. In most examples, the cylindrically-shaped element is positioned such that the element is axially centered on the support member to assure a symmetrical pressure profile on the element.

In one example the cylindrically-shaped element includes a photosensitive layer, and the apparatus is useful for treating the cylindrically-shaped photosensitive element by thermally developing the element to create a relief structure suitable for printing, such as a flexographic printing form or a letterpress printing form. The apparatus is capable of heating the photosensitive element having a layer of composition capable of being partially liquefied to a temperature sufficient to melt or soften or liquefy at least a portion of the layer for any purpose. In another example the cylindrically-shaped element is a support, and the apparatus is useful for treating the cylindrically-shaped element by forming a layer or modifying an existing layer on an exterior surface of the support to create a cylindrically-shaped printing form. The apparatus is capable of forming the layer of a photosensitive composition or other functional layer on the exterior surface of the support by suitable means including, but not limited to, laminating, extruding, calendering, and coating, to generate a cylindrically-shaped printing form in an uncured or raw state that can then be manipulated by any means to form a printing form having a relief surface. The cylindrically-shaped element may also be referred to herein as the cylindrical element, or simply the element.
The cylindrically-shaped element is tubular, i.e., a hollow elongated cylinder. The cylindrically-shaped element has an axial length taken along a longitudinal axis running through the hollow of the element. The axial length of the cylindrically-shaped element may also be referred to herein as a width of the element.

The apparatus and process of the present invention includes a means for moving the cylindrically-shaped element from a first position to a second position to appropriately locate the element for treating and/or to eject the element from the apparatus for easy collection by an operator. The means for moving the element may also be referred to as a device for positioning or a device for moving the element. The present apparatus and process provide an easy way to position the element at a desired location for treatment. In most examples, the desired location for treatment of the element is centered on an axial length of a support member or a support means, so that a symmetrical pressure profile across the element occurs during treatment. In other examples in which two or more elements are mounted on the support means for treatment, the desirable location may be to position each element at approximately equally spaced intervals on the support means. The use of the moving device in the apparatus also eliminates or reduces the possibility of an operator contacting hot or sharp surfaces within the apparatus during loading and unloading of the element from the apparatus. The use of the moving device also avoids the need for tools and rulers or similar means when positioning elements of small width relative to the axial length of the support.

In a particular example, the moving device is used in an apparatus for thermally developing a cylindrically-shaped photosensitive element in a loose-fit mode. In this example the cylindrically-shaped photosensitive element is a cylindrical printing element that includes a cylindrical support and a composition layer of a photopolymerizable composition on or adjacent the support opposite an interior surface of the support. The apparatus includes a means for supporting the element by contacting a first part of the interior surface of the element, i.e., the support. The apparatus may also include a second means for supporting the element by contacting a second part of the interior surface of the element (or the cylindrical support) different from the first part, wherein the element has one or more unsupported parts between the first part and the second part. The support means and the optional second support means each have an axial length, and a first end. The first support means and the second support means can each be considered a support member.

The cylindrical element that is positioned with the moving device of the present invention is partially supported by at least a first support means and optionally a second support means of the apparatus. The cylindrical element is not firmly fixed on a supporting cylinder, such as a drum or air shaft, during treating, but it is processed in a so-called "loose-fit" mode. In loose-fit mode, the interior surface of the cylindrical support of the element is not fully contacted or supported by a supporting member, e.g., cylinder; and only a part or parts of the interior surface are in contact with or supported by a supporting means. That is, in one example, one part of the interior surface circumference of the cylindrical support is contacted by or supported with the support means, such that the element has one part of the interior surface that is unsupported. That is, in another example, two or more parts of the interior surface circumference of the cylindrical support are contacted by or supported with the support means, such that the element resides about the support means in a band-like fashion. The cylindrical support has between the supported parts one or more parts of the interior surface that are unsupported. This loose fit mode is particularly useful for thermally treating of photosensitive elements in which the cylindrical support is a flexible sleeve and includes a continuous photopolymerizable layer on the sleeve. A suitable apparatus for thermal development of cylindrical printing elements in the loose fit mode is described for example in the United States Patent Application Pub. No. 2006/0104675 (EP1657593). The moving device of the present invention can advantageously be used in the apparatus disclosed in the United States Patent Application Pub. No. 2006/0104675 (EP1657593). It should be understood that the means for supporting the element in the apparatus of the present invention can be the first support means and/or the second support means of the apparatus as disclosed in United States Patent Application Pub. No. 2006/0104675 (EP1657593).

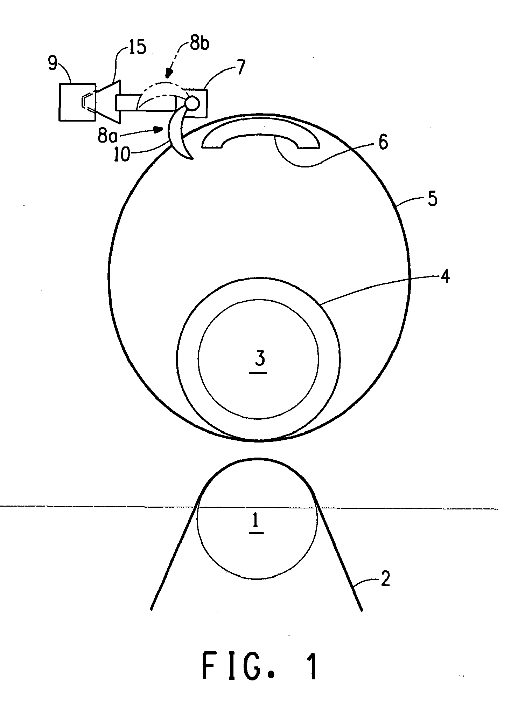

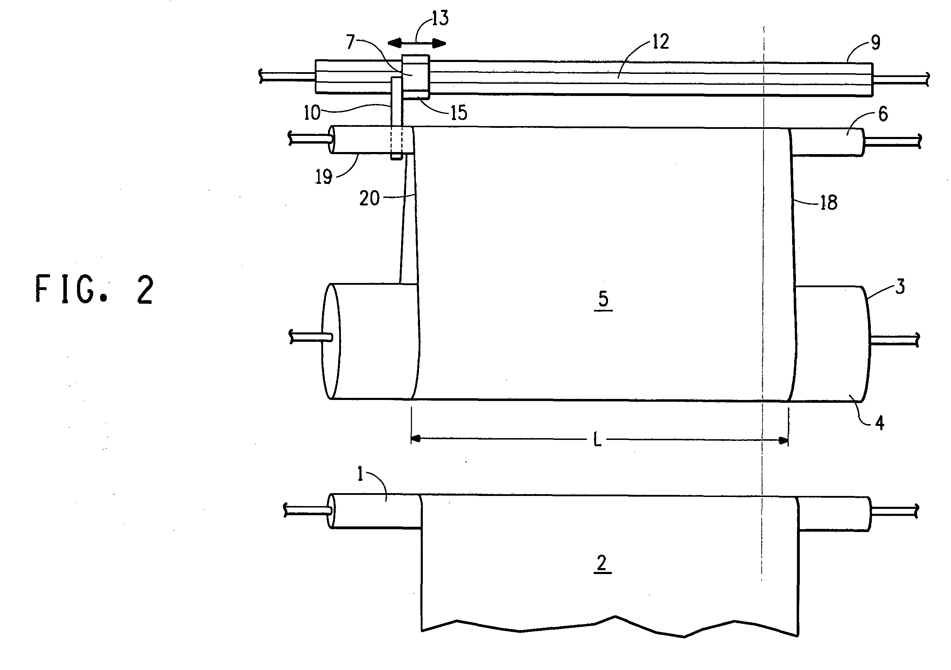

Figures 1 and 2 show one example of an apparatus for treating the cylindrically-shaped element in the loose-fit mode. The apparatus includes one example of a means for moving the element on a support member. In the example shown, the apparatus thermally develops an example of the cylindrical element 5 in which the element includes a photosensitive layer (not shown) that previously was imagewise exposed. The cylindrical element 5 has an axial length, L, measured between a first end 18 and a second end 20 of the element. The apparatus includes a first means for supporting 3 the cylindrical element by contacting a first part of an interior surface of the support of the cylindrical element, a second means for supporting 6 the cylindrical element by contacting a second part of the interior surface of the support of the cylindrical element different from the first part, and a contact roll 1 as a means for treating an exterior surface of the cylindrical element with a development medium 2. A means for moving the element 5 along the axial length of the second support means 6 includes a means swivelling 7 a finger 10 into and out of engagement with the cylindrical element 5 mounted to a linear positioning and guiding system or guide 9. In the example shown, the means for treating an exterior surface of the cylindrical element 5 is the contact roll 1 that carries a continuous web of a development medium 2 to remove unexposed (i.e., unpolymerized) portions of the photosensitive layer and form a relief structure for use as a printing form. In some examples, the contact roll 1 is heated, and may be referred to herein as a hot roll or heated roll. In other examples, the contact roll 1 is not heated.

In the example shown, the first means for supporting 3 the cylindrical element 5 is a roller covered with an adapter sleeve 4 having a compressible layer. The roller may be an air-shaft having radial passages for supplying air to an outer circumferential surface of the roller for ease in mounting or demounting the adapter sleeve 4 to and from the shaft. The roller, which may also be referred to as a "format cylinder", is capable of holding the adapter sleeve 4 with a special surface as described in the United States Patent Application Pub. No. 2006/0104675 (EP1657593). Alternate examples of the first means for supporting the interior surface of the cylindrical element include a drum, a roller, a plurality of rollers, and a platform member that can be planar or have an arc.

The second means for supporting 6 the interior surface of the cylindrical element has an outer surface having an arcuate shape contacting the second part of the cylindrical support of the element, which may be referred to as an "arc" or an arched platform member. The arc is moveable relative to the first support means 3 to account for supporting elements of various repeat lengths. Alternate examples of the second support means 6 are contemplated to include for example, a roller or narrow plate, such that the second means for supporting 6 is not limited to arcuate-shaped support members. The arc has an outer surface that can be treated for low friction by means of a coating based on fluorinated polymers, for example based on a Teflon^{®} coating. Teflon^{®} tape or other methods are for example known to reduce friction. Alternate examples of the second means for supporting the interior surface of the cylindrical element include a roller, a plurality of rollers, and a planar platform member.

As shown in Figures 1 and 2, one example of the means for moving the cylindrically-shaped element 5 is a moving assembly that includes a guide 9 supported in the apparatus, a platform 15 mounted for movement on the guide, and a finger 10 movably mounted on the platform and capable of engaging the element. The guide 9 is mounted in the apparatus adjacent the second supporting means 6 so that the guide is parallel or substantially parallel to a lengthwise axis of the second support means. The guide 9 may be fixed to an assembly of the arc 6 so that the guide moves together with the arc when elements of different repeat length are processed. One end of the platform 15 is mounted in or on a groove or rail 12 of the guide 9 so that the platform 15 is capable of linear movement, as indicated by arrow 13, along the guide 9. Mounted to the platform 15, opposite the end mounted on the guide 9, is the means for swivelling 7 the finger 10 into and out of engagement with a side of the element 5 between an "in" or engaged position 8a and an "out" or retracted position 8b (shown in phantom line). In the invention, the swivel mounted finger 10 is shaped such that in the engaged position 8a the finger contacts a side face or edge of the cylindrically-shaped element 5 to move the element along the axial length of the support member or support means. The finger 10 can be of any shape provided that when in the engaged position 8a the finger at least securely touches, and may sufficiently overlaps, with the side face of the cylindrical element 5. In an alternate example (not shown), the finger may include a grip or clamp that actively engages the element by capturing the side edge of the element. In one example of the engaged position 8a, the finger 10 has a leading end or tip that contacts the side face of the element 5 adjacent or close to the second support means 6. In another example, the tip of the finger 10 contacts the side face of the element 5 and lightly contacts an outer (axial or lengthwise) edge of the arc 6, such that the tip can glide along the edge of the arc using the arc as an additional guide as the finger is moved by the platform. The movement of the platform 15 on the guide 9 and the means for swivelling 7 the finger 10 are controlled by a programmable logic controller (PLC) of the apparatus to allow for precise positioning of the element to a desired location on the axial length of the support means. In the example shown, the guide 9 is positioned adjacent the second support means 6 having an arcuate shape, but is not so limited and in an alternate example can be positioned adjacent the first support means 3. In most examples, the desired location of the element is a position midway or about midway on the axial length of the support means and centered according to the width of the cylindrical element.

In the invention, the swivel mounted finger 10 has two fixed positions; the "in" or engaged position 8a, and the "out" or retracted position 8b. In the engaged position 8a, the finger 10 is in a position that contacts the side face of the cylindrical element 5 so that the element can be moved on the support means into the required position. The platform 15 moving on the guide 9 causes the finger 10 to push the element 5 into the desired axial position on the support means. In the retracted position 8b, the finger 10 is positioned so that it does not contact the cylindrical element 5. The finger 10 can be operated or swivelled from the retracted position 8b to the engaged position 8a, and vice versa, by any of several actuating means, such as for example by, a pneumatic cylinder, a motor, a magnet, and/or a hydraulic system. The movement of the finger 10 from one modus into the other is not dependent upon the size or type of cylindrical element.

One or more of the parameters of the cylindrically-shaped element, including the size of the element, such as its axial length and/or internal diameter, can be provided to the PLC by manually entering the size into a computer connected to the PLC, selecting from predetermined list of potential sizes of elements, and/or automatically detected by sensors appropriately positioned in the apparatus and connected to the PLC. Since the desired position of the element on the support means can be dependent upon axial length of the element, the PLC controls the movement of the platform 15 on the guide 9 to appropriately position the cylindrical element. The platform 15 can be driven on the guide 9 by any means including, for example, a motor, a pneumatic, or a hydraulic positioning system.

The operation of the process for positioning the cylindrical element is described relative to the example shown in Figures 1 and 2. The process begins by moving the first supporting means 3 and/or the second supporting means 6 sufficiently close together so that the element 5 will encompass both the first and second support means when being mounted. In most examples, the first and second support means are sufficiently close when the distance between diametrically opposite exterior surfaces of the first and second support means is less than an interior diameter of the element. In examples of the apparatus having only one support means, it may be useful but not necessary to move the support means into position for loading of the element. An operator manually mounts the element into the apparatus by placing a first end 18 of the cylindrical element 5 about a first end 19 of both the first support means 3 and second support means 6 so that the element encompasses both the support means, and then slides the element along the axial length of the support means 6,3. The element 5 is slid to an intake position in which a second end 20 (i.e., an end opposite the first end) of the element approximately coincides with the first end 19 of the support means, that is, the side face of the element 5 opposite the first end 18 is aligned or adjacent the first end 19 of the arc. A sensor detects the presence of the cylindrically-shaped element 5 on the support means and informs the PLC, which determines the distance to move the platform 15 on the guide 9 that will position the element on the support to the desired location. The platform 15 with the finger 10 in the retracted position 8b travels on the guide 9 from a home position, which is typically opposite the first end of the support means 6, to the intake position where the finger swivels into the engaged position 8a touching the side face of the element. The platform 15 moves along the groove or rail 12 in the guide 9 away from the intake position causing the finger 10 to push the element 5 on the support means 6 to the desired position. As soon as the element has reached the desired position, the finger 10 swivels to the retracted position 8b, the platform 15 returns to the home position, and treating begins. After treatment, the positioning device can be used to return the element 5 to the intake position for unloading from the apparatus. From the home position, the platform 15 moves along the guide 9 to position the finger 10 adjacent the first end 18 of the element 5, the finger 10 swivels into the engaged position 8a contacting the side face of the first end 18 of the element 5, and the platform continues moving away from the home position pushing the element toward the intake position until the second end 20 of the element coincides with the first end 19 of the support means 6.

In an alternate example, it is contemplated that the positioning device can continue to push the element for some predetermined distance after the second end of the element coincides with the first end of the support means to facilitate unloading of the element by the operator. In another example, it is contemplated that the positioning device can be used to appropriately position two or more elements adjacent to each other on the support means. In this case the first element is placed in the intake position and then further moved in with the second element when placing the second element in the intake position. Both elements are now in close contact at their edges. For intake both elements are treated as one element with the sum of widths and centered accordingly. After the treating step, both elements are moved to the intake position so that the first element can be removed. After that the positioning means can be activated again to move the second element to the intake position for removal.

The apparatus also includes a means for treating an exterior surface of the element opposite the interior surface. In one example, the cylindrically-shaped element is a support, and the apparatus is useful for treating the cylindrically-shaped element by forming a layer or modifying an existing layer on an exterior surface of the support to create a cylindrically-shaped printing form. The apparatus is capable of forming a layer of a photosensitive composition or other functional layer on the exterior surface of the cylindrical support by suitable means including, but not limited to, laminating, extruding, calendering, and coating, to generate a cylindrically-shaped printing form in an uncured or raw state. The uncured cylindrically-shaped printing form can then undergo any of various processes, e.g., imagewise expose, wet or dry development, to form a printing form having a relief surface. In another example, the apparatus is useful for treating a cylindrically-shaped element that includes a photosensitive layer by thermally developing the element to create a relief structure suitable for printing as a flexographic printing form to form a relief surface in the element. The apparatus is capable of heating the photosensitive element having a layer of composition capable of being partially liquefied to a temperature sufficient to melt or soften or liquefy at least a portion of the layer for any purpose.

### Treating by Thermal Development

Following imagewise exposure to actinic radiation the photosensitive element is thermally treated to remove unpolymerized areas in the photopolymerizable layer and thereby form a relief image. The thermal treating step removes at least the photopolymerizable layer in the areas that were not exposed to actinic radiation, i.e., the unexposed areas or uncured areas, of the photopolymerizable layer.

Treating the element thermally includes heating the photosensitive element having at least one composition layer, that is at least one photopolymerizable layer, (and optionally additional layer/s) to a temperature sufficient to cause the uncured portions of the photopolymerizable layer to soften or melt or flow. The exterior surface of the composition layer of the photosensitive element is heated to a temperature sufficient to cause a portion of the layer to liquefy. The thermal development process is conducted typically with more than one cycle of heating the element and contacting the element with the development medium in order to remove the uncured polymer to a suitable relief depth because uncured portions of the composition layer may only partially liquefy upon heating. In a preferred example, treating also includes contacting an outermost surface of the element to an absorbent surface to absorb or wick away the melt or flow portions. The polymerized areas of the photopolymerizable layer have a higher melting temperature than the unpolymerized areas and therefore do not melt, soften, or flow at the thermal development temperatures. Thermal development of photosensitive elements to form flexographic printing plates is described, for example, by Martens in U.S. Patents 5,015,556; 5,175,072; 5,215,859; and by Wang et al. in WO 98/13730.

The thermal treating steps of heating the photosensitive element and contacting an outermost surface of the element with development medium can be done at the same time, or in sequence provided that the uncured portions of the photopolymerizable layer are still soft or in a melt state when contacted with the development medium. The at least one photopolymerizable layer (and optionally additional layer/s) are heated by conduction, convection, radiation, or other heating methods to a temperature sufficient to effect melting of the uncured portions but not so high as to effect distortion of the cured portions of the layer. The photosensitive element is heated to a surface temperature above about 40°C, preferably from about 40°C to about 230°C (104-446°F) in order to effect melting or flowing of the uncured portions of the photopolymerizable layer. By maintaining more or less intimate contact of the development medium with the photopolymerizable layer that is molten in the uncured regions, a transfer of the uncured photosensitive material from the photopolymerizable layer to the development medium takes place. While still in the heated condition, the development medium is separated from the cured photopolymerizable layer in contact with the support layer to reveal the relief structure. A cycle of the steps of heating the photopolymerizable layer and contacting the molten (portions) layer with an absorbent material can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the development medium to the photopolymerizable layer (while the uncured portions are melt) may be maintained by pressing the layer and the development medium together.

The development medium is selected having a melt temperature exceeding the melt temperature of the uncured portions of the photopolymerizable layer and having good tear resistance at the same operating temperatures. Preferably, the selected material withstands the temperatures required to process the photosensitive element during heating. The development medium is selected from non-woven materials, paper stocks, fibrous woven material, open-celled foam materials, porous materials that contain more or less a substantial fraction of their included volume as void volume. The development medium can be in web or sheet form. The development medium should also possess a high absorbency for the molten elastomeric composition as measured by milligrams of elastomeric composition that can be absorbed per square centimeter of the development medium. Preferred is a non-woven web.

### Cylindrically-Shaped Element

The cylindrically-shaped element to be positioned by the moving device in the apparatus has an association with a cylindrical shape or substantially cylindrical shape. Cylindrically-shaped element encompasses cylindrical elements having one or more photosensitive layers pre-existing on the element, and cylindrical elements without a photosensitive layer, such as a support or sleeve. In one example, the cylindrically-shaped element may only be a support or a sleeve, and the apparatus prepares a cylindrical photosensitive element by treating the sleeve support to include one or more layers on the sleeve support. In another example, the cylindrically-shaped element may be a cylindrical photosensitive element as described in the following examples, which undergoes thermal treatment to make a printing form having a relief surface. The support for the element itself may be cylindrical, or the element may be grouped with at least one other structure that is cylindrically shaped. Since in one example the resulting printing form is ultimately mounted onto a printing cylinder, the shape of the support or structure is generally cylindrical. However, the element may not be cylindrical or may only be substantially cylindrically shaped while in operative engagement in the present apparatus and process or when not mounted onto the printing cylinder. The element may include a continuous, seamless or substantially seamless, photopolymerizable composition layer adjacent to or on the cylindrically-shaped support. The element can also encompass plate-on-sleeve system. Typically, plate-on-sleeve is a cylindrically-shaped element that includes at least the composition layer on a planar support, i.e., a plate, which is then mounted onto a cylindrically- shaped support. Ends of the plate may or may not meet or join when wrapped onto the sleeve. Plate-on-sleeve also includes an example in which more than one plate, or portions of plates, are mounted onto a sleeve at various spaced locations. Also contemplated as the element is a photosensitive plate having at least one photopolymerizable composition layer preferably on a base support, which is formed into a cylinder by butt joining both edges. The plate edges can be joined by any method including, but not limited to, melt fusing, taping, stitching, clamping, stapling, taping, gluing, and sewing. In this example the base support would become the cylindrical support. Any of the examples that include the photosensitive layer as described above may be referred to as cylindrical printing elements or cylindrical printing forms. The cylindrical printing form has an interior surface having an interior diameter and an interior circumference (i.e., the perimeter of the interior surface). In one example, the printing element has been image-wise exposed to actinic radiation thereby polymerizing the photosensitive composition layer in the exposed areas.

## Claims

1. An apparatus for treating a cylindrically-shaped printing element (5) having a side edge comprising:
means (6) for supporting the element adapted to contact a first part of an interior surface of the element, the supporting means having an axial length; and
means for moving the element along the axial length of the supporting means, said means for moving the element comprising a guide (9) supported in the apparatus, and a finger (10) mounted for linear movement on the guide and capable of engaging the element by contacting the side edge of the element, wherein the guide is adjacent to and parallel to the means for supporting,
the means for moving further comprises a means for swivelling (7) the finger into and out of engagement with the element,
wherein said apparatus further comprises means for actuating the linear movement on the guide.

2. The apparatus of Claim 1 wherein the means for actuating the linear movement on the guide is selected from the group consisting of pneumatic cylinder, motor, magnet and hydraulic system.

3. The apparatus of Claim 1 further comprising a means for determining an axial position of the cylindrically-shaped element on the means for supporting.

4. The apparatus of Claim 1 wherein the supporting means is selected from the group consisting of a drum, a roller, a plurality of rollers, and a platform member.

5. A process for positioning a cylindrically-shaped element having an interior surface and a side edge comprising:
supporting the element by contacting a first part of an interior surface of the element on a support member having an axial length;
engaging a finger into contact with the side edge of the element; and
moving the finger on a guide to position the element on the support member, and
swivelling the finger into and out of contact with the side edge,
wherein the moving step comprises actuating the finger for linear movement on the guide.

6. The process of Claim 5 wherein the moving finger transports the element from a first position to a second position on the axial length of the support member.

7. The process of Claim 6 further comprising determining the second position, on the support member.

8. The process of Claim 6 further comprising determining an axial length of the element and determining the second position on the support member based on the axial length of the element.

9. The process of Claim 5 further comprising supporting an interior surface of a second element having a side edge on the support member, engaging a finger into contact with the side edge of the second element; and moving the finger on the guide to position the second element on the support member.

## Patentansprüche

1. Vorrichtung für die Behandlung eines zylinderförmigen Druckelementes (5) mit einem Seitenrand, die aufweist:
ein Mittel (6) für das Tragen des Elementes, das ausgebildet ist, um einen ersten Teil einer Innenfläche des Elementes zu berühren, wobei das Tragmittel eine axiale Länge aufweist; und
ein Mittel für das Bewegen des Elementes entlang der axialen Länge des Tragmittels, wobei das Mittel für das Bewegen des Elementes eine Führung (9), die in der Vorrichtung gehalten wird, und einen Finger (10) aufweist, der für eine lineare Bewegung in der Führung montiert und in der Lage ist, durch Berühren des Seitenrandes des Elementes mit dem Element in Eingriff zu kommen, wobei die Führung dem Mittel für das Tragen benachbart und parallel dazu ist,
wobei das Mittel für das Bewegen außerdem ein Mittel (7) für das Schwenken des Fingers in und außer Eingriff mit dem Element aufweist,
wobei die Vorrichtung außerdem ein Mittel für das Auslösen der linearen Bewegung in der Führung aufweist.

2. Vorrichtung nach Anspruch 1, bei der das Mittel für das Auslösen der linearen Bewegung in der Führung aus der Gruppe ausgewählt wird, die aus einem Druckluftzylinder, Motor, Magneten und Hydrauliksystem besteht.

3. Vorrichtung nach Anspruch 1, die außerdem ein Mittel für das Ermitteln einer axialen Position des zylinderförmigen Elementes am Mittel für das Tragen aufweist.

4. Vorrichtung nach Anspruch 1, bei der das Tragmittel ausgewählt wird aus der Gruppe, die aus einer Trommel, Rolle, Vielzahl von Rollen und einem Plattformelement besteht.

5. Verfahren zur Positionierung eines zylinderförmigen Elementes mit einer Innenfläche und einem Seitenrand, das die folgenden Schritte aufweist:
Tragen des Elementes durch Berühren eines ersten Teils einer Innenfläche des Elementes an einem Tragelement mit einer axialen Länge;
Ineingriffbringen eines Fingers in Kontakt mit dem Seitenrand des Elementes; und
Bewegen des Fingers in der Führung, um das Element am Tragelement zu positionieren; und
Schwenken des Fingers in und außer Kontakt mit dem Seitenrand,
wobei der Schritt des Bewegens das Auslösen des Fingers für eine lineare Bewegung in der Führung aufweist.

6. Verfahren nach Anspruch 5, bei dem der sich bewegende Finger das Element aus einer ersten Position in eine zweite Position auf der axialen Länge des Tragelementes transportiert.

7. Verfahren nach Anspruch 6, das außerdem den Schritt des Ermittelns der zweiten Position am Tragelement aufweist.

8. Verfahren nach Anspruch 6, das außerdem die Schritte des Ermittelns einer axialen Länge des Elementes und des Ermittelns der zweiten Position am Tragelement aufweist, basierend auf der axialen Länge des Elementes.

9. Verfahren nach Anspruch 5, das außerdem die folgenden Schritte aufweist: Tragen einer Innenfläche eines zweiten Elementes mit einem Seitenrand auf dem Tragelement; Ineingriffbringen eines Fingers in Kontakt mit dem Seitenrand des zweiten Elementes; und Bewegen des Fingers in der Führung, um das zweite Element am Tragelement zu positionieren.

## Revendications

1. Appareil permettant un traitement d'un élément d'impression de forme cylindrique (5) présentant un bord latéral comprenant :
un moyen (6) permettant de soutenir l'élément, adapté pour venir en contact avec une première partie d'une surface intérieure de l'élément, le moyen de soutien présentant une longueur axiale ; et
un moyen permettant de déplacer l'élément le long de la longueur axiale du moyen de soutien, ledit moyen permettant de déplacer l'élément comprenant un guide (9) soutenu dans l'appareil, et un doigt (10) monté pour un mouvement linéaire sur le guide et capable de mettre en prise l'élément en venant en contact avec le bord latéral de l'élément, dans lequel le guide est adjacent et parallèle au moyen permettant de soutenir,
le moyen permettant de déplacer comprend en outre un moyen (7) permettant de pivoter le doigt afin qu'il vienne en prise et ne soit plus en prise avec l'élément,
dans lequel ledit appareil comprend en outre un moyen permettant d'actionner le mouvement linéaire sur le guide.

2. Appareil selon la revendication 1, dans lequel le moyen permettant d'actionner le mouvement linéaire sur le guide est sélectionné parmi le groupe constitué d'un vérin pneumatique, d'un moteur, d'un aimant et d'un système hydraulique.

3. Appareil selon la revendication 1, comprenant en outre un moyen permettant de déterminer une position axiale de l'élément de forme cylindrique sur le moyen permettant de soutenir.

4. Appareil selon la revendication 1, dans lequel le moyen de soutien est sélectionné parmi le groupe constitué d'un tambour, d'un rouleau, d'une pluralité de rouleaux, et d'un élément formant plateforme.

5. Procédé permettant de positionner un élément de forme cylindrique présentant une surface intérieure et un bord latéral comprenant les étapes consistant à :
soutenir l'élément en venant en contact avec une première partie d'une surface intérieure de l'élément sur un élément de soutien présentant une longueur axiale ;
mettre en prise un doigt en le faisant venir en contact avec le bord latéral de l'élément ; et
déplacer le doigt sur un guide pour positionner l'élément sur l'élément de soutien, et
pivoter le doigt afin qu'il vienne en contact et ne soit plus contact avec le bord latéral,
dans lequel l'étape de déplacement comprend l'actionnement du doigt pour un mouvement linéaire sur le guide.

6. Procédé selon la revendication 5, dans lequel le doigt en déplacement transporte l'élément d'une première position vers une seconde position sur la longueur axiale de l'élément de soutien.

7. Procédé selon la revendication 6, comprenant en outre l'étape consistant à déterminer la seconde position sur l'élément de soutien.

8. Procédé selon la revendication 6, comprenant en outre les étapes consistant à déterminer une longueur axiale de l'élément et à déterminer la seconde position sur l'élément de soutien en se basant sur la longueur axiale de l'élément.

9. Procédé selon la revendication 5, comprenant en outre les étapes consistant à soutenir une surface intérieure d'un second élément présentant un bord latéral sur l'élément de soutien, mettre en prise un doigt en le faisant venir en contact avec le bord latéral du second élément ; et déplacer le doigt sur le guide pour positionner le second élément sur l'élément de soutien.
